# EUROPÄISCHE PATENTSCHRIFT

(11) **EP 3 788 390 B1**
(45) Veröffentlichungstag und Bekanntmachung des Hinweises auf die Patenterteilung: **04.10.2023**
(21) Anmeldenummer: 19720357.3
(22) Anmeldetag: 26.03.2019
(51) Int. Cl.: G01R 33/02, G01R 33/18, G01R 33/028, H01P 7/00

(54) **MIKROWELLENRESONATOR-MAGNETFELDMESSVORRICHTUNG SOWIE MAGNETFELDMESSVERFAHREN**
MICROWAVE RESONATOR MAGNETIC FIELD MEASURING DEVICE AND MAGNETIC FIELD MEASURING METHOD
DISPOSITIF DE MESURE DE CHAMP MAGNÉTIQUE À RÉSONATEUR À MICRO-ONDES, AINSI QUE PROCÉDÉ DE MESURE DE CHAMP MAGNÉTIQUE

(30) Priorität: 02.05.2018 DE 102018110511
(43) Veröffentlichungstag der Anmeldung: 10.03.2021
(73) Patentinhaber: Christian-Albrechts-Universität zu Kiel, 24118 Kiel (DE)
(72) Erfinder: TOXVAERD, Sebastian, 6000 Kolding (DK); KNÖCHEL, Reinhard, 25336 Elmshorn (DE); QUANDT, Eckhard, 24226 Heikendorf (DE); THORMÄHLEN, Lars, 24103 Kiel (DE)
(86) Internationale Anmeldenummer: PCT/DE2019/100286
(87) Internationale Veröffentlichungsnummer: WO 2019/210900

(56) Entgegenhaltungen:
- WO-A1-2010/088011
- WO-A1-2017/210373
- WO-A1-2018/071993
- US-A1- 2014 145 244
- US-B1- 9 454 061

## Beschreibung

Die Erfindung betrifft eine Magnetfeldmessvorrichtung zur Messung von magnetischen Wechselfeldern mit einer Grundplatte und einem Cantilever mit wenigstens einer magnetostriktiven Schicht. Ferner betrifft die Erfindung ein Magnetfeldmessverfahren mit einer erfindungsgemäßen Magnetfeldmessvorrichtung.

Im Sinne dieser Offenbarung werden Mikrowellenresonator-Magnetfeldmessvorrichtungen auch als magnetoelektrische Sensoren, kurz auch ME-Sensoren, verstanden bzw. bezeichnet. Ferner werden im Sinne dieser Offenbarung Cantilever auch als Biegebalken oder mit weiteren Schichten darauf als mechanischer Schwinger bezeichnet.

Aus dem **Stand der Technik** sind unterschiedliche Anordnungen bekannt, bei denen konventionelle ME-Sensoren ein magnetisches Wechselfeld über ein magnetostriktives Material in eine Längenänderung umsetzen, welche in einer piezoelektrischen Schicht eine Polarisationsänderung und damit eine Klemmenspannung als Messsignal hervorrufen. Es sind auch ME-Sensoren bekannt, bei denen die durch die Längenänderung verursachte mechanische Auslenkung optisch detektiert wird, beispielsweise mittels Laser.

Magnetoelektrische Dünnfilme werden bisher in Verbindung mit Mikrowellen als Filter eingesetzt. Dabei wird meist ein Yttrium Eisen Granat (YIG) Film auf eine Mikrowellenleitung aufgebracht. Wird nun eine Mikrowelle mit einer Frequenz in der Nähe der ferromagnetischen Resonanz, nachfolgend auch FMR, angelegt, wird diese in das aufgebrachte Substrat eingekoppelt und bei der FMR teilweise absorbiert bzw. transmittiert, was eine Filterwirkung hervorruft, offenbart in Tsai, Chen S.; Su, Jun 1999: "A wideband electronically tunable microwave notch filter in yttrium iron garnetgallium arsenide material structure" In Appl. Phys. Lett. 74 (14), pp. 2079-2080. DOI : 10.1063/1.123763.

Aus der Druckschrift "Millimeter-wave magnetoelectric effects in bilayers of barium hexaferrite and lead zirconate titanate" von Srinivasan, G.; Zavislyak, I.V.; Tatarenko, A. S. 2006 "Millimeter-wave magnetoelectric effects in bilayers of barium hexaferrite and lead zirconate titanate". In Appl. Phys. Lett. 89 (15), p. 152508. DOI: 10.1063/1 .2360901 ist bekannt, dass über ein magnetisches Gleichfeld die FMR verschoben werden kann, was eine Verstimmung des Filters bewirkt. Über eine piezoelektrische Schicht kann die FMR über den inversen magnetoelektrischen Effekt auch über eine angelegte Spannung verändert werden. Ziel ist in der Regel die Abstimmbarkeit der Filter.

Ferner ist aus der Veröffentlichung "Electronically Tunable Miniaturized Antennas on Magnetoelectric Substrates With Enhanced Performance" von Yang, Guo-Min; Xing, X.; Daigle, A.; Liu, M.; Obi, O.; Wang, J. W. et al. 2008: "Electronically Tunable Miniaturized Antennas on Magnetoelectric Substrates With Enhanced Performance" In IEEE Trans. Magn. 44 (11), pp. 3091-3094. DOI: 10.1109/TMAG.2008.2003062 eine Anwendung der Abstimmbarkeit und Ausnutzung der Mikrowellenresonanz bei Antennen bekannt. So entstandene nanoelektromagnetische (NEMS) Resonatoren können auch als Sensoren für die Messung von kleinen magnetischen Gleichfeldern verwendet werden, vgl. "Self-biased 215 MHz magnetoelectric NEMS resonator for ultra-sensitive DC magnetic field detection", Nan, Tianxiang; Hui, Yu; Rinaldi, Matteo; Sun, Nian X 2013: "Self-biased 215 MHz magnetoelectric NEMS resonator for ultra-sensitive DC magnetic field detection" In Scientific reports 3, p. 1985. DOI: 10.1038/srep01985. In Abhängigkeit eines angelegten Gleichfeldes ändert sich die Impedanz des Resonators bei der Mikrowellenfrequenz, die damit in Amplitude und Phase verstimmt wird. Dabei lässt sich auch die elektro-mechanische Resonanz des NEMS Resonators ausnutzen, um das Ausgangssignal zu steigern. Es wird ein Sensor mit mechanischer Resonanzfrequenz um 215 MHz beschrieben, der piezoelektrisch angeregt und ausgelesen wird. Das Messprinzip basiert auf der Veränderung der Resonanz durch eine Änderung des E-Moduls im Messmagnetfeld, dem delta E-Effekt, wobei sich dieses zur Messung von zeitlich konstanten Magnetfeldern eignet.

Ferner sind aus dem Übersichtsartikel von Patrick Pons, Hervé Aubert, Manos Tentzeris, "Overview of Electromagnetic Transducers with Radar Interrogation for Passive Wireless Sensors Applications", International Conference on Microwaves, Radar and Wireless Communications (MIKON), Jun 2014, Gdansk, Poland <hal-01024205> fernabfragbare Sensoren auf Basis von HF-Resonatoren (>> 1 GHz) für verschiedene physikalische Messgrößen bekannt, wobei auch als weitere Quellen die Druckschriften US 2014 049 268 A1 und US 2005 241 403 A1 zu nennen sind.

Weiter sind aus den Druckschriften US 6,404,304 B1 und US 7,339,446 B2 verstimmbare Mikrowellenfilter in MEMS-Bauweise zu entnehmen, bei denen ein biegbares Element ("elastic member") zur Kontrolle der HF-Resonanzfrequenz dient.

Aus der Druckschrift WO 2017/210373 A1 ist eine nanomechanische magnetoelektrische Antenne bekannt, die eine Dünnfilm-Heterostruktur umfasst, die ein magnetisches Element und ein piezoelektrisches Element aufweist, wobei die Heterostruktur auf einem Substrat aufgehängt und in der Lage ist, bei akustischen Resonanzfrequenzen zu resonieren. Im Übertragungsmodus der Antenne wird die oszillierende mechanische Spannung, die durch spannungsinduzierte akustische Wellen erzeugt wird, durch dehnungsvermittelte magnetoelektrische Kopplung auf die Dünnfilm-Heterostruktur übertragen. Dies führt zu einer Magnetisierungsschwingung oder einem magnetischen Strom, der elektromagnetische Wellen bei den akustischen Resonanzfrequenzen abstrahlt. Im Empfangsmodus erfasst die Heterostruktur magnetische Komponenten der an der Antenne ankommenden elektromagnetischen Wellen und wandelt diese in einen piezoelektrischen Spannungsausgang um.

Weiter ist aus der Druckschrift US 9,454,061 B1 ein quantenkohärentes Umwandlungsschema von Mikrowellen in optische Systeme unter Verwendung eines mechanischen Elements und eines Squid's bekannt. Hierbei ist ein mechanischer Resonator so konfiguriert, dass er bei einer mechanischen Resonanzfrequenz mit einer Verschiebung in einer Achse oszilliert. Ein optischer Resonator umfasst einen ersten Spiegel gegenüber einem zweiten Spiegel, zwischen denen ein optischer Hohlraum gebildet wird. Der erste Spiegel ist an dem mechanischen Resonator befestigt, so dass der erste Spiegel bewegt wird, um eine optische Länge des optischen Hohlraums entsprechend der Verschiebung des mechanischen Resonators zu ändern. Die Änderung der optischen Länge verändert eine optische Resonanzfrequenz des optischen Resonators. Ein Mikrowellenresonator wird so positioniert, dass er sich entsprechend der Verschiebung des mechanischen Resonators so bewegt, dass die Bewegung des mechanischen Resonators eine Josephson-Induktivität des Mikrowellenresonators ändert, wodurch eine Mikrowellenresonanzfrequenz des Mikrowellenresonators geändert wird.

Ferner ist aus der Druckschrift WO 2010/088011 A1 ein System zur Fernerfassung bekannt, wobei dieses eine mikroelektromechanische Sensor-(MEMS)-Vorrichtung umfasst, die ein Sensorelement, ein Anregungselement, um das Sensorelement bei Resonanzfrequenz von einem entfernten Ort in Resonanz zu versetzen, indem Signale übertragen werden, die eines von akustischen Signalen, optischen Signalen, Hochfrequenzsignalen oder magnetischen Induktionssignalen umfassen, und eine Leseschaltung umfasst, um eine Originalfrequenz des Sensorelements von einem entfernten Ort zu lesen, um so einen Zustand zu bestimmen, dem die MEMS-Vorrichtung ausgesetzt ist, wobei Signale verwendet werden, die eines von akustischen Signalen, optischen Signalen, Hochfrequenzsignalen oder magnetischen Induktionssignalen umfassen.

Die Druckschrift US 2014/145244 A1 offenbart MEMS-Bauelemente für Anwendungen mit geringem Widerstand. In einem ersten Punkt umfasst die MEMS-Vorrichtung einen MEMS-Wafer mit einem Handle-Wafer mit einem oder mehreren Hohlräumen, der/die eine erste Oberfläche und eine zweite Oberfläche und eine auf der zweiten Oberfläche des Handle-Wafers aufgebrachte Isolierschicht enthält/enthalten. Die MEMS-Vorrichtung enthält auch eine Vorrichtungsschicht mit einer dritten und vierten Oberfläche, wobei die dritte Oberfläche mit der Isolierschicht der zweiten Oberfläche des Handle-Wafers verbunden ist, und eine leitende Metallschicht auf der vierten Oberfläche. Die MEMS-Vorrichtung umfasst auch einen CMOS-Wafer, der mit dem MEMS-Wafer verbunden ist. Der CMOS-Wafer enthält mindestens eine Metallelektrode, so dass eine elektrische Verbindung zwischen der mindestens einen Metallelektrode und mindestens einem Teil der leitenden Metallschicht gebildet wird.

Aus der Druckschrift WO 2018/071993 A1 ist ferner ein Sensorelement für ein intrinsisches Gravitationsgradiometer zur Verwendung bei der Erfassung von Veränderungen in einem Gravitationsfeld an einem Ort bekannt. Das Fühlerelement ist flexibel, länglich und hat unbefestigte gegenüberliegende Enden, wenn es Teil des Schwerkraftgradiometers ist. Das Fühlerelement kann ein Metallband sein und kann durch eine Anzahl von z.B. 3 oder 5, Drehpunkten oder Achsen an jeder der gegenüberliegenden Seiten entlang des Fühlerelements montiert werden, wobei die gegenüberliegenden Enden des Fühlerelements frei beweglich sind. Die Drehpunkte oder Achsen können Stifte enthalten, vorzugsweise zylindrische Stifte, oder das Sensorelement kann in die Seitenwand geätzt werden und mit dem Rest der Seitenwand durch Verbindungen verbunden bleiben. Das Sensorelement kann Teil eines oder mehrerer Resonanzhohlräume oder Wellenleiter sein, wie z.B. eine Seiten- oder Trennwand oder ein Teil davon. Eine Zweiphasen-Brückenanordnung kann vorgesehen werden. Elektrischer Strom kann in das Sensorelement eingespeist werden. Eine Vorwärtsbewegungskompensation (MC oder FFMC) kann als Teil der Strombestimmung angewendet werden. Das Einspeisen von elektrischem Strom in die gegenüberliegenden Längsseiten, wie z.B. die rechte und linke Seite des Sensorelements, wie z.B. ein Band, kann für mehrere Arten der Kompensation verwendet werden. Die Verschiebung des Sensorelements kann durch einen Resonanzhohlraum, einen elektromagnetischen Sensor oder einen optischen Sensor erfasst werden.

Das Messen von zeitabhängigen und schwachen Magnetfeldern gelingt u. a. mit magnetoelektrischen Sensoren, kurz ME-Sensoren, die üblich einen Materialverbund mit wenigstens einer magnetostriktiven und einer piezoelektrischen Materialphase in mechanischer Kopplung miteinander umfassen. Die magnetostriktive Phase erfährt dabei durch das Magnetfeld eine Längenänderung, die sich über die mechanische Kopplung auf die piezoelektrische Phase überträgt und eine messbare elektrische Spannung hervorruft. Ist das Magnetfeld zeitlich periodisch oder gar harmonisch, dann vollführt der ME-Sensor eine oszillierende Bewegung, und es hat sich bewährt, ihn als Schwinger auszugestalten. Bei Anregung des Schwingers in seiner mechanischen Resonanz bewirkt die Überhöhung der Schwingungsamplitude, dass sehr schwache Magnetfelder bereits große Spannungssignale hervorrufen. Dies ist der Grund für die Empfindlichkeit z.B. eines ME-Bimorphs, der gewöhnlich aus zwei Schichten und ggf. einem Substrat besteht.

Die resonante Schwingung kann unmittelbar durch das periodische Magnetfeld angeregt werden. Miniaturisierte ME-Schwinger weisen jedoch Resonanzen im hohen Kilohertz-Bereich auf, während sich die hier interessierenden biomagnetischen Felder im Frequenzband unterhalb von 200 Hz befinden. Mittels eines Modulationsmagnetfeldes nahe der mechanischen Resonanzfrequenz des Schwingers kann ein niederfrequentes Magnetfeld in die Resonanz umgesetzt werden, offenbart in der Druckschrift EP 2 635 913 B1.

Alternativ ist dies auch, offenbart in der Druckschrift EP 3 104 186 A1 durch das Anlegen einer Drive-Spannung an die piezoelektrische Phase des ME-Sensors möglich, sofern diese eine nicht-lineare Längenänderung mit der Drive-Spannung aufweist. Die elektrisch vermittelte Frequenzumsetzung ist technisch deutlich leichter zu realisieren als ein magnetisches Modulationsfeld, allerdings stört die Drive-Spannung als Großsignal auch das Spannungs-Messsignal des ME-Sensors.

Eine weitere Störquelle für das magnetoelektrische-Sensorsignal ist das thermische Rauschen der piezoelektrischen Phase. Ferner ist noch das diesbezügliche Problem der Sensitivität zu nennen, das insbesondere bei schwachen beispielsweise biologischen Magnetfeldern zum Tragen kommt.

Der vorliegenden Erfindung liegt die **Aufgabe** zugrunde, eine Mikrowellenresonator-Magnetfeldmessvorrichtung zur Messung von magnetischen Wechselfeldern sowie ein dazugehöriges Magnetfeldmessverfahren aufzuzeigen, wobei diese eine einfachere Herstellung insbesondere auch von magnetoelektrischen Dünnschicht-Sensoren, kurz auch ME-Sensoren, zur Messung von kleinsten magnetischen Wechselfeldern unterschiedlicher Frequenz ermöglichen soll.

Ferner soll das Auslesen derartiger Mikrowellenresonator-Magnetfeldmessvorrichtung einfacher als bisher werden, wobei insbesondere Störeffekte und Rauschquellen in der Messung und / oder Auswertung eliminiert werden sollen, wobei insbesondere das thermische Rauschen der piezoelektrischen Schicht problematisch im Stand der Technik ist.

Ferner soll es möglich sein, eine weitere Miniaturisierung derartiger Mikrowellenresonator-Magnetfeldmessvorrichtungen zu ermöglichen, insbesondere derartige Sensoren zu miniaturisieren.

Ferner sollen weitere Einstellmöglichkeiten geschaffen werden, die eine Verbesserung der Messung ermöglichen.

Ein Erfindungsgedanke soll weiterhin auch darauf gerichtet sein, dass eine technologische einfache Herstellung ermöglicht wird, nämlich beispielsweise das bewusste Weglassen von Komponenten des Standes der Technik, wie beispielsweise der Piezoschicht, wobei bestimmte vorhandene Rauschquellen der konventionellen Auslesemethoden nicht mehr auftreten sollen, z.B. das Rauschen der Piezoschicht, und dass durch die Nutzung zweier unabhängiger Resonanzen die Sensitivität beispielsweise durch die Variation der Mikrowellen-Güte variiert werden soll.

**Gelöst** werden diese Aufgaben mit einer Magnetfeldmessvorrichtung zur Messung von magnetischen Wechselfeldern gemäß Hauptanspruch sowie einem Magnetfeldmessverfahren mit einer erfindungsgemäßen Magnetfeldmessvorrichtung gemäß nebengeordnetem Anspruch bzw. den jeweils untergeordneten Ansprüchen.

Die Mikrowellenresonator-Magnetfeldmessvorrichtung zur Messung von magnetischen Wechselfeldern umfasst eine Grundplatte mit wenigstens einem Abstütz-/Lager-/Einspannpunkt, wenigstens einen als Mikrowellen-Resonator ausgebildeten mechanischen Schwinger in Form eines Cantilevers mit wenigstens einer magnetostriktiven Schicht, wobei dieser wenigstens an einer Stelle mit der Grundplatte in dem wenigstens einen Abstütz-/Lager-/Einspannpunkt verbunden und gelagert ist, wenigstens eine Einkopplung für Mikrowellen und wenigstens eine Auskopplung für Mikrowellen wobei die Grundplatte und der als Mikrowellen-Resonator ausgebildete mechanische Schwinger wenigstens teilweise elektrisch leitfähig ausgebildet und miteinander elektrisch leitfähig verbunden sind, dadurch gekennzeichnet, dass bei Betrieb der Mikrowellenresonator-Magnetfeldmessvorrichtung die mechanische Auslenkung des mechanischen Schwingers durch Einwirken eines zu messenden magnetischen Wechselfeldes auf die magnetostriktive Schicht mittels des integrierten Mikrowellen-Resonators detektiert wird.

Die Erfindung schlägt in einem ersten Aspekt vor, zur Signalauskopplung auf das Piezo-Elektrikum zu verzichten und stattdessen die magnetostriktive Phase als Bestandteil einer veränderlichen oder beweglichen Komponente eines verstimmbaren Mikrowellen-Resonators vorzusehen. Mikrowellen- oder HF-Resonatoren sind üblich passive elektrische Schwingkreise, in die kapazitiv oder induktiv oszillierende elektromagnetische Felder ein- und ausgekoppelt werden können. Die HF-Resonanzfrequenz dieser Schwingkreise wird durch ihre Feldenergiespeicher, mithin durch ihre Form, bestimmt, und sie können als effektive Frequenzfilter wirken, da sie in entsprechender Ausführung nur Signale in ihrer HF-Resonanz passieren lassen bzw. wieder aussenden.

Erfolgt nun erfindungsgemäß durch Einwirken eines zu messenden Magnetfeldes auf die magnetostriktive Phase eine Änderung wenigstens eines der Feldspeicher des HF-Resonators, so ändert sich dessen HF-Resonanzfrequenz entsprechend im Takt des einwirkenden Magnetfeldes, wodurch sich im Prinzip hieraus bereits Amplitude und Frequenz des Magnetfeldes ablesen lassen.

Insbesondere kann in einer besonders bevorzugten Ausführungsform die Mikrowellenresonator-Magnetfeldmessvorrichtung Piezoschicht-frei auslesbar ausgebildet sein, so dass eine die piezoelektrische Schicht weggelassen werden kann, was wiederum die technologische Komplexität verringert und das thermisch-elektrische Rauschen der piezoelektrischen Schicht vermeidet. Weiter kann zudem auf einen Ladungsverstärker verzichtet werden, dessen Verstärkung von der Sensorkapazität abhängig ist und dessen Rückkopplungsnetzwerk entsprechend angepasst werden müsste.

Die mechanische Auslenkung wird mit Hilfe eines zusätzlich integrierten Hochfrequenz-Mikrowellen-Resonators detektiert, was sich vorteilhaft zur Empfindlichkeitssteigerung ausnutzen lässt und technologische Schritte bei der Herstellung spart.

Durch die Auslesung über die Mikrowelle wird die piezoelektrische Schicht auf dem Sensor überflüssig und das thermische Rauschen durch die piezoelektrischen Verluste entfällt vollständig.

Die Erfindung gestattet zudem die Anwendung von magnetischen Frequenzumsetzungsverfahren, mit denen niederfrequente (z.B. biomagnetische) Signale in der mechanischen Resonanz des mechanischen Schwingers gemessen werden können. Durch das nichtlineare Verhalten der Magnetisierung des Sensors wird ein niederfrequentes Signal in die mechanische Resonanz des mechanischen Schwingers umgesetzt und dann über die Mikrowelle ausgelesen.

Die Einkopplung für Mikrowellen und/oder die Auskopplung für Mikrowellen erfolgt besonders bevorzugt kapazitiv oder induktiv. Es sind entsprechende Einkopplungs- und Auskopplungspunkte für die Mikrowellen vorgesehen.

In der Grundplatte kann insbesondere bevorzugt eine Abstimmschraube und/oder eine einstellbare Reaktanz und/oder eine Geometrieverstellung zur Verstimmung des als Mikrowellen-Resonator ausgebildeten mechanischen Schwingers vorgesehen sein, so dass eine Einstellmöglichkeit des Resonators gegeben ist.

Der Gütefaktor des Resonators kann beispielsweise über die Mikrowellen-Resonanz eingestellt werden, beispielsweise durch Verstellen der Abstimm- bzw. der Stimmschraube oder Variieren der Verkopplung, was eine Abstimmung der Signalstärke ermöglicht.

Der als Mikrowellen-Resonator ausgebildete mechanische Schwinger kann in einer bevorzugten Ausführungsvariante in genau einem Punkt an einem der Enden oder in der Mitte oder in genau zwei Punkten, dem ersten und dem zweiten Ende des als Mikrowellen-Resonator ausgebildeten mechanischen Schwingers gelagert sein.

Durch die elektromagnetischen Felder fließen hochfrequente Ströme, die sich im Bereich der Skin-Eindringtiefe konzentrieren, wobei die Erfindung entsprechend optional vorsieht, die Oberfläche des Sensors in diesem Bereich möglichst leitfähig zu gestalten, was beispielsweise durch eine Ummantelung des mechanischen Schwingers mit einer Goldschicht entsprechender Dicke erfolgen kann. Hierdurch wird die Güte des Mikrowellen-Resonators gesteigert.

Es wird vorgeschlagen, den Cantilever auf seiner gesamten Oberfläche elektrisch gut leitend auszubilden, beispielsweise durch einen Goldüberzug.

Die Länge des mit einer gut leitfähigen Schicht versehenen Abschnitts des Cantilevers beträgt insbesondere sinnvollerweise λW/2 oder λµW/4, also die Hälfte bzw. ein Viertel der Mikrowellen-Wellenlänge. Die magnetostriktive Schicht unterhalb der gut leitfähigen Schicht kann über die volle oder auch nur einen Teil der Länge aufgebracht sein.

Die Mikrowellenresonator-Magnetfeldmessvorrichtung kann als Hohlraumresonator ausgebildet sein.

Die magnetostriktive Schicht kann insbesondere als Dünnschicht auf dem Cantilever ausgebildet sein.

Weiter bzw. alternativ kann die magnetostriktive Schicht selbst als Cantilever ausgebildet sein.

Bei diesen zuvor genannten zwei Varianten wird diesseits auf miniaturisierte Magnetfeldsonden abgezielt, bei denen die magnetostriktive Phase in Dünnschichttechnologie auf Cantilevern abgeschieden bzw. selbst als Cantilever aufgebaut wird. Hier wird vorzugsweise die Resonanzüberhöhung der mechanischen Schwingung der Cantilever ausgenutzt werden, um auch schwache Felder zu detektieren. Die Anregung der Cantilever kann dabei elektrisch über ein Piezoelement erfolgen, welches allerdings nur als Antrieb und nicht mehr zur Signalauskopplung dient, was die bisherigen Störungen im Stand der Technik vermeidet. Dabei kann auch die Frequenzumsetzung des zu messenden Magnetfeldes in die mechanische Resonanz des Cantilevers wie zuvor erfolgen.

Die HF-Resonanzfrequenz (> 1 GHz) liegt typisch wenigstens drei Größenordnungen über der mechanischen Resonanzfrequenz (< 1 MHz), d.h. aus Sicht des HF-Resonators erfolgt seine Verstimmung auch im "doppelt resonanten" Betrieb durch den schwingenden Cantilever langsam.

Die Mikrowellenresonator-Magnetfeldmessvorrichtung kann besonders bevorzugt Piezoschicht-frei ausgebildet sein, wobei sich diese Piezoschicht-Freiheit auf die Signalauskoppelbarkeit bezieht. Ein Erregen mittels einer Piezo-Transducer Schicht soll weiterhin möglich sein können, so dass zwar ein Erregen möglich ist, jedoch gerade ein Auslesen über eine piezoelektrische Schicht bevorzugt nicht möglich oder gar ausgeschlossen werden sollte.

Die Mikrowellenresonator-Magnetfeldmessvorrichtung kann insbesondere kontaktlos auslesbar und/oder fernauslesbar ausgebildet sein.

Der als Mikrowellen-Resonator ausgebildete mechanische Schwinger kann in einer Ausführungsvariante über ein Piezo-Transducer-Element elektrisch anregbar ausgebildet sein.

Um die Güte der Anordnung zu erhöhen, kann die Anordnung auch als Hohlraumresonator ausgelegt werden, als dessen Deckel ein zweiseitig eingespannte Bieger fungiert. Ein angelegtes Wechselfeld wird den Bieger wiederum in Schwingung versetzen und die Resonanzfrequenz im Resonator variieren.

Da der Sensor in einem Hohlraum eingeschlossen werden kann, können externe akustische oder elektrische Störungen bereits durch die Anordnung abgeschirmt werden.

So genannte "Stimmgabelsensoren" zur Unterdrückung von Gleichtaktstörungen sind auch möglich.

Bei dem Magnetfeldmessverfahren mit einer erfindungsgemäßen Mikrowellenresonator-Magnetfeldmessvorrichtung wird die Mikrowellenresonator-Magnetfeldmessvorrichtung insbesondere in der Grundvariante in Mikrowellen-Resonanz betrieben.

In einer bevorzugten Ausführungsform wird die Mikrowellenresonator-Magnetfeldmessvorrichtung in doppelter Resonanz betrieben, wobei dies in Mikrowellen-Resonanz und in mechanischer Resonanz erfolgt, wobei hierbei ein Verstimmen des Mikrowellen-Resonators durch den zugleich in mechanischer Resonanz schwingenden mechanischen Schwinger erfolgt.

Ein weiterer Vorteil kann sich bei Verwendung von zwei getrennten Resonanzfrequenzen derart ergeben, da beide Frequenzen individuell eingestellt werden können, was wiederum neue Abstimmungsmöglichkeiten ermöglicht.

Ferner kann ein Fernauslesen des / der Mikrowellenresonator-Magnetfeldmessvorrichtung erfolgen, wobei die Schwingung des als Mikrowellen-Resonator ausgebildeten mechanischen Schwingers ohne eigene Energieversorgung durch ein Einstrahlen von gepulster oder intensitätsmodulierter elektromagnetischer Strahlung hoher Energie angeregt wird und ein Auslesen dessen Reaktion / Antwort über Mikrowellenstrahlung erfolgt.

Als diesbezüglich weiterer Aspekt der Erfindung ergibt sich also bei der Ausgestaltung des Magnetfeldsensors als fernauslesbare Einheit ohne eigene Energieversorgung. Es ist demnach möglich, die Schwingung des Cantilevers durch die Einstrahlung von gepulster oder intensitätsmodulierter EM-Strahlung hoher Energie anzuregen und seine Antwort über eine breitbandige Mikrowellenabfrage niedriger Energie auszulesen. Der Sensor verhält sich dabei wie ein modulierter Streukörper. Die Modulation bzw. ihr a priori unbekannter Anteil beruht dabei unmittelbar auf dem am Ort des Sensors und entlang des Cantilevers zu messenden wirksamen Niederfrequenz-Magnetfeld.

Hierbei verhält sich die Mikrowellenresonator-Magnetfeldmessvorrichtung als ein modulierter Streukörper und die Modulation bzw. der a priori unbekannte Anteil beruht unmittelbar auf dem am Ort der Mikrowellenresonator-Magnetfeldmessvorrichtung und entlang des als Mikrowellen-Resonator ausgebildeten mechanischen Schwingers wirksamen Magnetfeldes.

Eine weitere besonders bevorzugte Ausgestaltungsvariante wird in der Ausgestaltung als passives System gesehen, wobei dem System Energie durch gepulste oder intensitätsmodulierte elektromagnetische Strahlung zugeführt wird, während gleichzeitig eine Abfrage des Sensors mit Mikrowellenstrahlung erfolgt. Die Pulsrate bzw. Modulationsfrequenz der Energie zuführenden Strahlung sind dabei auf die HF-Resonanz des Schwingkreises abgestimmt.

Diese Variante stellt jedoch eine interessante Alternative zum klassischen ME-Bimorph dar, dessen Eigenschaften auch in dieser Technologieoffenbarung die Grundlage der Auslegung bilden. Der neue Sensor kann ohne elektrische Spannungsversorgung und insbesondere ohne äußere Anschlüsse ausgestaltet sein. Vielmehr kann er als autonome Einheit in einer magnetisch neutralen Hülle, z.B. aus Kunststoff, gekapselt ausgestaltet sein. Dies lässt neue Einsatzmöglichkeiten, etwa im Außenraum unter Witterung oder sonstigen korrodierenden Bedingung oder auch im Inneren lebender Organismen zu.

Weiterhin kann eine Mehrzahl solcher Sensoren in einem Raumgebiet nach Belieben verteilt und einzeln oder zusammen von einem Nutzer abgefragt werden, der eine entsprechende EM-Strahlungsquelle ausrichtet. Die Technologie der Erfindung basiert auf der von ME-Sensoren bekannten Magnetostriktion mit Resonanzüberhöhung kombiniert mit bekannter und bereits umgesetzter HF-Resonatortechnik.

Zur Miniaturisierung oder zur Einführung eines Fernzugriffs kann das Layout des Mikrowellen-Resonators leicht verändert werden.

Die zum Auslesen benötigten Geräte sind beispielsweise Standard-Mikrowellengeräte.

Mögliche Anwendungsgebiete derartiger Magnetfeldmessvorrichtungen bzw. Sensoren sind beispielsweise bzw. auch insbesondere zerstörungsfreies Testen von Materialien, die Messung biomagnetischer Signale wie Herzsignale, beispielweise über Magnetokardiografie, oder die Lokalisation von Hirnschrittmacher-Elektroden.

Bevorzugte Ausführungsformen und Funktionsweisen:
Bei der erfindungsgemäßen Mikrowellenresonator-Magnetfeldmessvorrichtung, auch als Dünnschicht-ME-Sensor bezeichnet, wird ein magnetostriktiv beschichteter Biegebalken zusätzlich als Mikrowellen-Resonator betrieben. Dazu kann der Biegebalken insbesondere als mechanischer Schwinger der Länge einer viertel oder halben Wellenlänge der Mikrowelle über einer elektrisch leitenden Fläche einseitig oder beidseitig eingespannt ausgebildet sein. Über Magnetostriktion ändert sich die Länge I oder Höhe h des so entstandenen Mikrowellenresonators und damit dessen Resonanzfrequenz proportional zur momentanen Stärke des zu messenden Magnetfeldes. Die Höhe des Biegebalkens über der leitenden Ebene / Grundplatte wird dabei möglichst klein, aber größer als die maximale Schwingungsamplitude des Biegers bei transversaler mechanischer Bewegung gewählt. Über kapazitive oder induktive Kopplungen wird eine Mikrowelle in den Resonator eingespeist und wieder ausgekoppelt. Durch eine spezielle Anordnung der Ein- und Auskopplung kann das Mikrowellensignal durch den Sensor in Amplitude und Phasenwinkel verändert werden. Eine Abstimmschraube kann insbesondere eine zusätzliche mechanische Abstimmung der Mikrowellenresonanz erlauben.

Ein schwaches magnetisches Feld kann nun dadurch gemessen werden, dass
a) der ein- oder beidseitig eingespannte ME-Sensor durch ein magnetisches Feld in seiner mechanischen Resonanz zum Schwingen mit einer erhöhten Amplitude angeregt wird;
b) ein zusätzliches magnetisches Gleichfeld kann die Bewegung des Sensors außerdem verändern;
c) die mechanische Bewegung verschiebt die Mikrowellenresonanz in Amplitude und Phase;
d) Amplitude und/oder Phase der Mikrowelle kann durch günstige Ausgestaltung der elektromagnetischen Resonanz besonders stark beeinflusst und verändert werden;
e) gleichzeitig kann sowohl in mechanischer als auch in elektromagnetischer Resonanz gearbeitet werden, wobei diese sich weitgehend unabhängig voneinander einstellen lassen, wodurch Resonanzüberhöhungen doppelt ausgenutzt werden können;
f) die Ausgestaltung der Vorrichtung kann so gewählt werden, dass die Abhängigkeit der Verschiebung sich möglichst linear zum zu messenden magnetischen Wechselfeld verhält.

Die Vorteile der Erfindung lassen sich nachfolgend zusammenfassen:
- Die Sensoren sind miniaturisierbar durch das Auslesen über Hochfrequenz (HF), was einen klaren Vorteil gegenüber im Stand der Technik üblichen Auslesemethoden wie beispielsweise optisch über Laser ergibt;
- technologisch einfach herzustellen, da auf die piezoelektrische Schicht zur Signalauskopplung verzichtet werden kann;
- die Integrierbarkeit mit HF Verstärkern ist auf einfachste Weise nunmehr möglich;
- die Ausnutzung zweier Resonanzen ergibt deutlich mehr Einstellmöglichkeiten, insbesondere ist ein präzises Einstellen der Mikrowellen (µw)-Resonanzen möglich, was bei den konventionellen Ausleseverfahren überhaupt nicht möglich ist;
- es handelt sich um ein technologisch einfacheres Herstellverfahren für derartige Sensoren, da durch den bewussten Verzicht der piezoelektrischen Schicht einfachere Sensoren realisiert werden können;
- durch den Verzicht auf die piezoelektrische Schicht entfällt auch wenigstens eine Rauschquelle, nämlich unter Anderem diejenige im Verstärker und in der piezoelektrischen Schicht selbst, bedingt durch das thermische Rauschen;
- ein Auslesen nach dem Sensor ist durch die HF-Technologie nicht mehr störanfällig;
- ferner ist erstmals ein Auslesen über Funkmodule mit anderem Frequenzbereich möglich;
- eine Vakuumverkapselung ist durch Anordnung als Kavität angezeigt bzw. möglich;
- das erfindungsgemäße Verfahren erlaubt auch ein Auslesen mit anderen Ansteuerungsmethoden, wie bspw. Delta E;
- die Vorrichtung in Form des Sensors sowie das Verfahren haben ein hohes Potential zur einfachen drahtlosen Abfrage von einer Mehrzahl von Sensoren, die in einem räumlich verteilten Netzwerk angeordnet sind.

Nachfolgend werden weitere Ausführungsbeispiele bzw. -formen der Erfindung anhand der beiliegenden Zeichnungen in der **Figurenbeschreibung** beschrieben, wobei diese die Erfindung erläutern sollen und nicht beschränkend zu werten sind:

Es zeigen:
- Fig. 1: eine schematische Darstellung eines ersten Ausführungsbeispiels des erfindungsgemäßen Mikrowellenresonator-Magnetfeldsensors 1 in einer Aufsicht;
- Fig. 2: eine schematische Darstellung des ersten Ausführungsbeispiels des erfindungsgemäßen Mikrowellenresonator-Magnetfeldsensors 1 aus Fig. 1 in einem Schnitt bzw. schematischen Seitenansicht;
- Fig. 3: eine schematische Darstellung eines zweiten Ausführungsbeispiels des erfindungsgemäßen Mikrowellenresonator-Magnetfeldsensors 1 in einer räumlichen Schrägansicht;
- Fig. 4: eine schematische Darstellung eines dritten Ausführungsbeispiels des erfindungsgemäßen Mikrowellenresonator-Magnetfeldsensors 1 in einer schematischen Seitenansicht;
- Fig. 5: eine schematische Darstellung eines vierten Ausführungsbeispiels des erfindungsgemäßen Mikrowellenresonator-Magnetfeldsensors 1 in einer schematischen Seitenansicht;
- Fig. 6: eine schematische Darstellung eines fünften Ausführungsbeispiels des erfindungsgemäßen Mikrowellenresonator-Magnetfeldsensors 1 in einer schematischen Seitenansicht;
- Fig. 7: eine schematische Darstellung eines sechsten Ausführungsbeispiels des erfindungsgemäßen Mikrowellenresonator-Magnetfeldsensors 1 in einer schematischen Seitenansicht;
- Fig. 8: eine schematische Darstellung eines siebten Ausführungsbeispiels des erfindungsgemäßen Mikrowellenresonator-Magnetfeldsensors 1 in einer räumlichen Schrägansicht;
- Fig. 9: eine schematische Darstellung eines achten Ausführungsbeispiels des erfindungsgemäßen Mikrowellenresonator-Magnetfeldsensors 1 in einer Aufsicht;
- Fig. 10: eine schematische Darstellung des achten Ausführungsbeispiels des erfindungsgemäßen Mikrowellenresonator-Magnetfeldsensors 1 in einer schematischen Seitenansicht;
- Fig. 11: eine schematische Darstellung eines neunten Ausführungsbeispiels des erfindungsgemäßen Mikrowellenresonator-Magnetfeldsensors 1 in einer Aufsicht;
- Fig. 12: eine schematische Darstellung des neunten Ausführungsbeispiels des erfindungsgemäßen Mikrowellenresonator-Magnetfeldsensors 1 in einer schematischen Seitenansicht;
- Fig. 13: eine schematische Darstellung eines zehnten Ausführungsbeispiels des erfindungsgemäßen Mikrowellenresonator-Magnetfeldsensors 1 in einer Aufsicht;
- Fig. 14: eine schematische Darstellung des zehnten Ausführungsbeispiels des erfindungsgemäßen Mikrowellenresonator-Magnetfeldsensors 1 in einer schematischen Seitenansicht;
- Fig. 15: eine schematische Darstellung eines elften Ausführungsbeispiels des erfindungsgemäßen Mikrowellenresonator-Magnetfeldsensors 1 in einer räumlichen Schrägansicht;
- Fig. 16: eine schematische Darstellung eines zwölften Ausführungsbeispiels des erfindungsgemäßen Mikrowellenresonator-Magnetfeldsensors 1 in einer räumlichen Schrägansicht;
- Fig. 17: eine schematische Darstellung eines Ausführungsbeispiels eines Ausführungsbeispiels einer Frequenzdiskriminatorerkennung für den magnetoelektrischen µw-Resonator und
- Fig. 18: eine schematische Darstellung eines Ausführungsbeispiels des magnetoelektrischen µw-Resonatorsystems in einem Blockschaltbild.

An dieser Stelle soll nochmals darauf hingewiesen werden, dass die hier dargestellten Ausführungsbeispiele die Erfindung nur erläutern und nicht in Ihrem Schutzbereich beschränken sollen.

Zum Verständnis der Erfindung wird auf die Bezugszeichenliste verwiesen, aus der die einzelnen Elemente und Merkmale, die in den Figuren beschrieben und dargestellt werden, entsprechend entnehmbar sind.

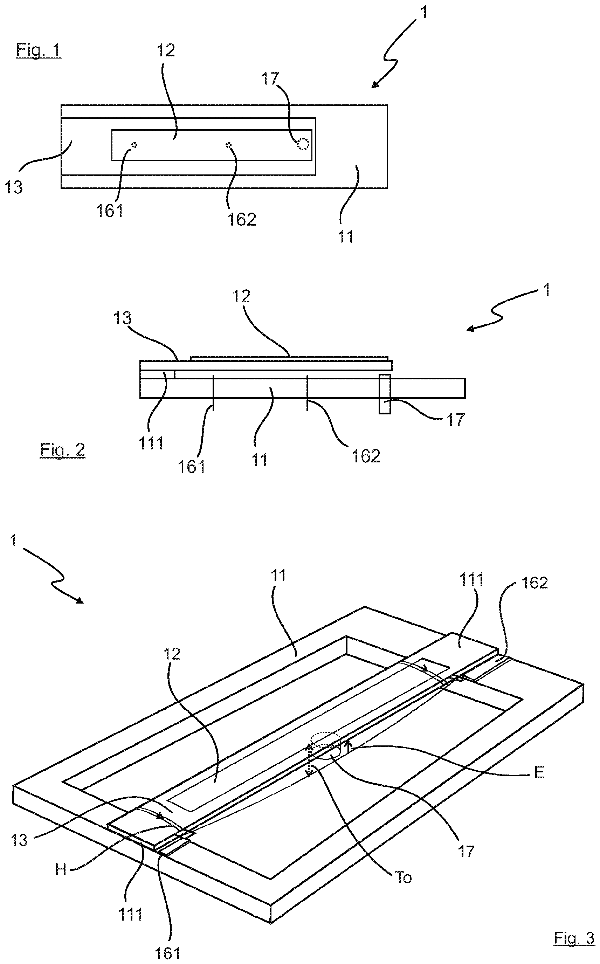

In Fig. 1 ist eine schematische Darstellung eines ersten Ausführungsbeispiels des erfindungsgemäßen Mikrowellenresonator-Magnetfeldsensors 1 in einer Aufsicht dargestellt.

Der Mikrowellenresonator-Magnetfeldsensor 1 umfasst eine Grundplatte 11 und einen daran über einen Cantilever-Abstütz-/Lager-/Einspannpunkt 111 angeordneten Cantilever 13, der eine magnetostriktive Schicht 12 aufweist. Der Cantilever 13 mit der magnetostriktiven Schicht 12 bilden zusammen einen mechanischen Schwinger 12 + 13, wobei dieser einseitig gelagert auf der Grundplatte 11 befestigt ist.

Hierbei sind in der Grundplatte 11 eine Einkopplung 161 und eine Auskopplung 162 für Mikrowellen vorgesehen.

Ferner ist noch eine Abstimmschraube 17 in der Grundplatte 11 vorgesehen.

Die Grundplatte 11 und der als Mikrowellen-Resonator ausgebildete mechanische Schwinger 12 + 13 sind wenigstens teilweise elektrisch leitfähig ausgebildet und miteinander elektrisch leitfähig verbunden.

Das Mikrowellen-Signal kann beispielsweise kapazitiv mit Standard-SMA-Steckverbindungen über die Einkopplung 161 eingekoppelt werden, wobei der entsprechende Innenleiter über die Oberfläche der Grundplatte 11 hinausragen kann und dessen überstehende Länge die Kopplungsstärke beeinflusst.

Die Grundplatte 11 kann beispielsweise aus Kupfer gefertigt sein.

Zur Herstellung einer durchgängigen elektrischen Verbindung können insbesondere elektrisch leitfähige Kleber verwendet werden, um den mechanischen Schwinger 12 + 13 in dem Cantilever-Abstütz-/Lager-/Einspannpunkt 111 zu befestigen.

Die vorgesehene Abstimmschraube 17 wird bevorzugt in der Nähe des maximalen elektrischen Feldes des Resonators positioniert, wobei je kleiner der Abstand zwischen Abstimmschraube 17 und mechanischen Schwinger 12 + 13 ist, desto geringer ist die Resonanz-Frequenz des Resonators und umso höher der gemessene Q-Faktor. Die Abstimmschraube 17 kann manuell auf den nächstgelegenen Abstand zum mechanischen Schwinger 12 + 13 eingestellt werden, wobei der Stromkreis nicht kurzgeschlossen werden darf.

Als mögliche Materialien des mechanischen Schwingers 12 + 13 können Si-Freischwinger verwendet werden, die beispielsweise vollständig mit Ta und verschiedenen Au-Dicken beschichtet sein können.

Insbesondere kann der Cantilever 13 vollständig mit einem leitfähigen Material wie Gold bedeckt sein, wobei dessen Dicke größer als die Leitschichtdicke (Skin-Effekt) sein kann.

An dieser Stelle sei darauf hingewiesen, dass die Position der µw-Kopplung frei gewählt werden kann.

Fig. 2 zeigt eine schematische Darstellung des ersten Ausführungsbeispiels des erfindungsgemäßen Mikrowellenresonator-Magnetfeldsensors 1 aus Fig. 1 in einem Schnitt bzw. schematischen Seitenansicht.

Fig. 3 zeigt eine schematische Darstellung eines zweiten Ausführungsbeispiels des erfindungsgemäßen Mikrowellenresonator-Magnetfeldsensors 1 in einer räumlichen Schrägansicht.

Hierbei ist der mechanische Schwinger 12 + 13 zweiseitig auf der Grundplatte 11 gelagert.

Die entsprechende transversale Oszillation Tₒ ist ebenso dargestellt. Ebenso sind die entsprechenden elektrischen Felder / E-Feld E und magnetischen Felder / H-Held H dargestellt.

Es ist quasi ein magnetoelektrischer Resonator mit Mikrowellenstreifenleitung ausgebildet.

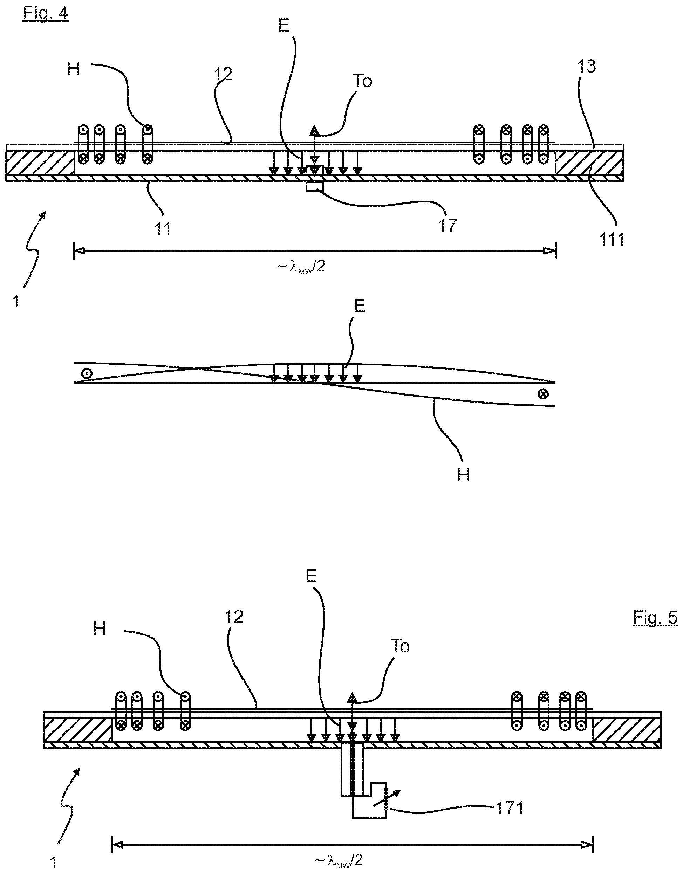

In Fig. 4 ist eine schematische Darstellung eines dritten Ausführungsbeispiels des erfindungsgemäßen Mikrowellenresonator-Magnetfeldsensors 1 in einer schematischen Seitenansicht gezeigt.

Hierbei ist eine beidseitige Lagerung des mechanischen Schwingers 12 + 13 auf der Grundplatte 11 vorgesehen. In der Mitte ist die entsprechende Abstimmschraube 17 angeordnet.

Ferner sind die E-Felder und H-Felder dargestellt.

Fig. 5 zeigt eine schematische Darstellung eines vierten Ausführungsbeispiels des erfindungsgemäßen Mikrowellenresonator-Magnetfeldsensors 1 in einer schematischen Seitenansicht.

Hierbei ist ebenfalls eine beidseitige Lagerung des mechanischen Schwingers 12 + 13 auf der Grundplatte 11 vorgesehen. In der Mitte ist alternativ zur Abstimmschraube 17 eine einstellbare Reaktanz 171 angeordnet.

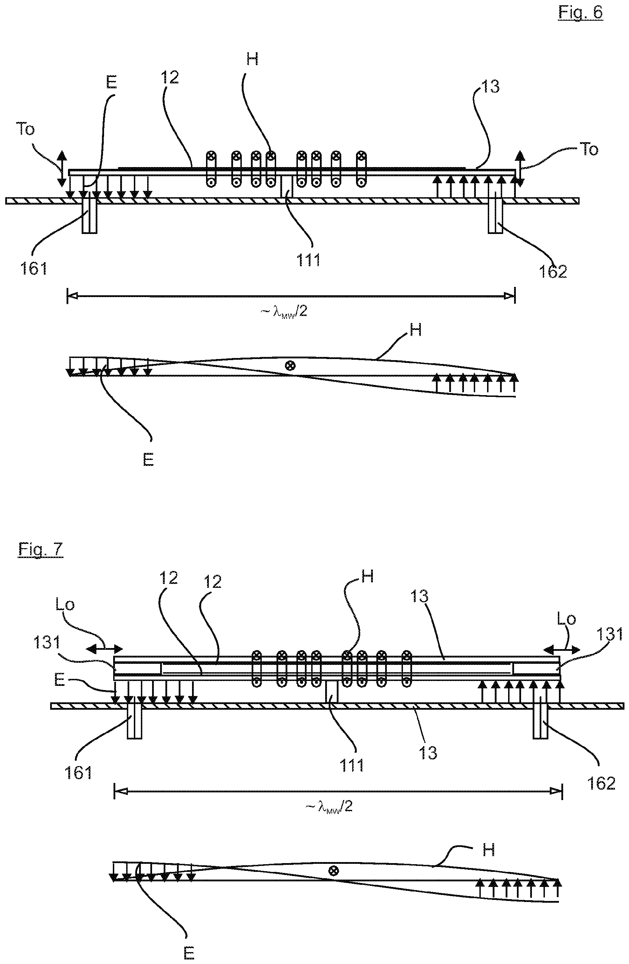

In Fig. 6 wird eine schematische Darstellung eines fünften Ausführungsbeispiels des erfindungsgemäßen Mikrowellenresonator-Magnetfeldsensors 1 in einer schematischen Seitenansicht gezeigt.

Hierbei ist eine mittige Lagerung des mechanischen Schwingers 12 + 13 vorgesehen, wobei im Außenbereich des Cantilevers 13 eine kapazitive Ein- 161 bzw. Auskopplung 162 für Mikrowellen vorgesehen ist.

Die entsprechenden E-Felder und H-Felder sind dazugehörig dargestellt.

Fig. 7 zeigt eine schematische Darstellung eines sechsten Ausführungsbeispiels des erfindungsgemäßen Mikrowellenresonator-Magnetfeldsensors 1 in einer schematischen Seitenansicht.

Hierbei sind zwei mechanische Schwinger 12 + 13 mit zueinander ausgerichteten magnetostriktiven Schichten 12 auf der jeweiligen Cantilever-Oberfläche 13 dargestellt, wobei diese über eine Cantilever-Beabstandung 131 zueinander derart beabstandet sind, dass diese frei schwingen können und sich dabei nicht berühren.

Hierdurch werden Gleichtaktstörungen unterdrückbar, da quasi eine Stimmgabelsensorik ausgebildet ist.

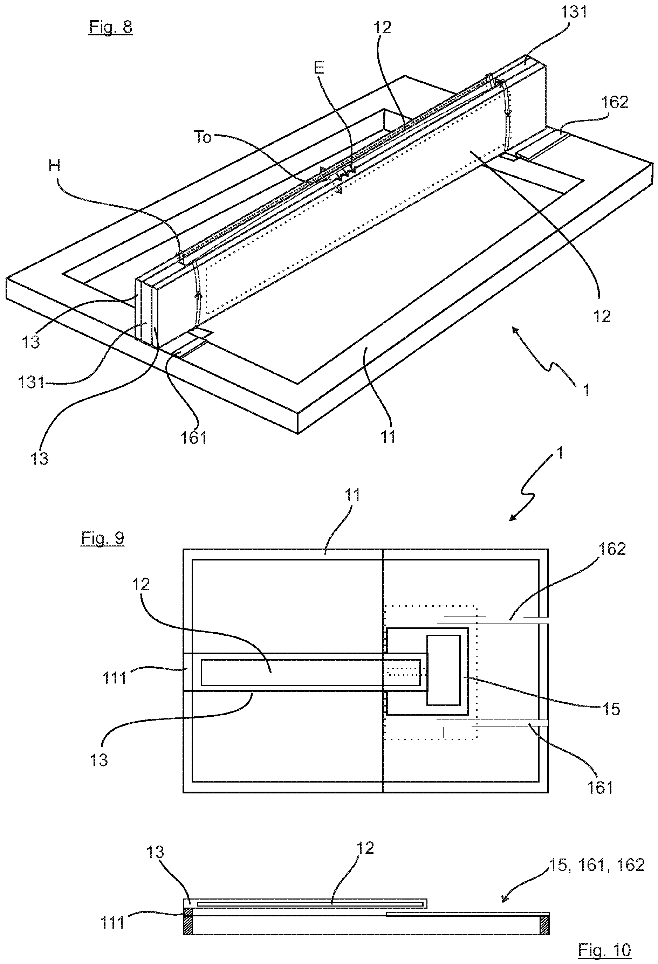

Fig. 8 zeigt eine schematische Darstellung eines siebten Ausführungsbeispiels des erfindungsgemäßen Mikrowellenresonator-Magnetfeldsensors 1 in einer räumlichen Schrägansicht.

Hierbei handelt es sich um eine im Vergleich zu Fig. 7 um 90° gedrehte Stimmgabelresonatoranordnung mit Mikrowellenbandleitung.

Fig. 9 erläutert eine schematische Darstellung eines achten Ausführungsbeispiels des erfindungsgemäßen Mikrowellenresonator-Magnetfeldsensors 1 in einer Aufsicht.

Hierbei ist eine erste Ausführungsform eines miniaturisierten Mikrowellenresonators 1 dargestellt. Es handelt sich um einen einseitig gelagerten Cantilever 13 mit magnetostriktiver Schicht 12, der an einer Grundplatte 11 in einem Cantilever- Abstütz-/Lager-/Einspannpunkt 111 angeordnet ist.

Es sind entsprechende Mittel zur Einkopplung 161 und Auskopplung 162 vorgesehen. Ferner ist ein entsprechender Mikrowellenresonator in Mikrostreifenleitertechnik 15 vorgesehen. Eine mögliche Realisierung ist hierbei in Form eines Split-Ring Resonators gegeben.

In Fig. 10 ist eine schematische Darstellung des achten Ausführungsbeispiels des erfindungsgemäßen Mikrowellenresonator-Magnetfeldsensors 1 in einer schematischen Seitenansicht gezeigt.

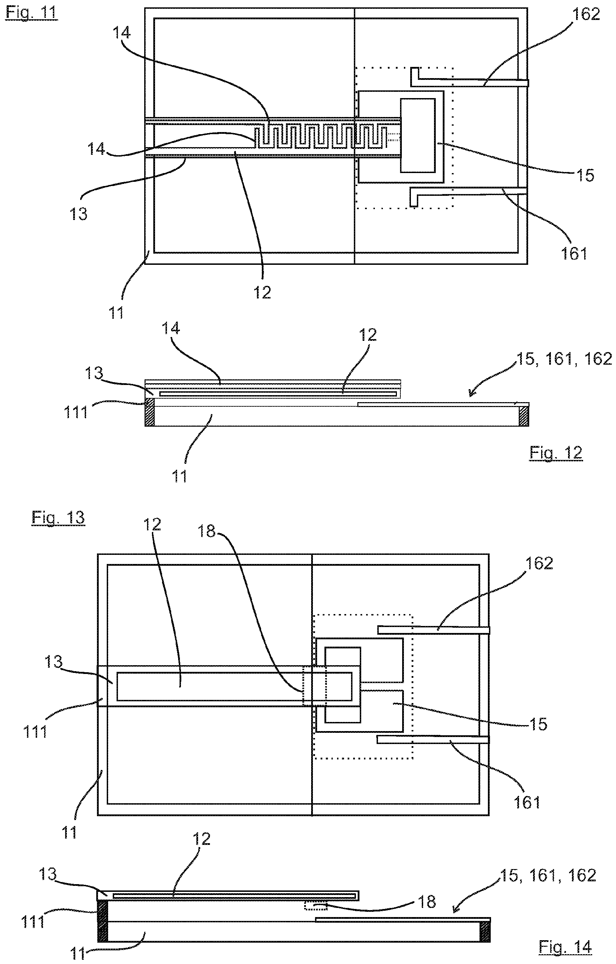

Fig. 11 zeigt eine schematische Darstellung eines neunten Ausführungsbeispiels des erfindungsgemäßen Mikrowellenresonator-Magnetfeldsensors 1 in einer Aufsicht.

Hierbei ist ergänzend ein Piezo-Transducer 14 auf dem Cantilever 13 vorgesehen, wobei dieser gerade nicht zum Auslesen verwendet wird, sondern ausschließlich zum Anregen des als Mikrowellen-Resonator ausgebildeten mechanischen Schwingers 12 + 13 dient, so dass der Cantilever 13 in Schwingungen versetzt wird. Mögliche Ausbildungsformen für den Piezo-Transducer 14 umfassen unter anderen IDT Elektroden und Plattenkondensator Elektroden.

Fig. 12 zeigt eine schematische Darstellung des neunten Ausführungsbeispiels des erfindungsgemäßen Mikrowellenresonator-Magnetfeldsensors 1 in einer schematischen Seitenansicht.

In Fig. 13 ist eine schematische Darstellung eines zehnten Ausführungsbeispiels des erfindungsgemäßen Mikrowellenresonator-Magnetfeldsensors 1 in einer Aufsicht gezeigt.

Hierbei ist ein Ferrit-Element 18 auf der Unterseite des Cantilevers 13 angeordnet.

Fig. 14 zeigt eine schematische Darstellung des zehnten Ausführungsbeispiels des erfindungsgemäßen Mikrowellenresonator-Magnetfeldsensors 1 in einer schematischen Seitenansicht.

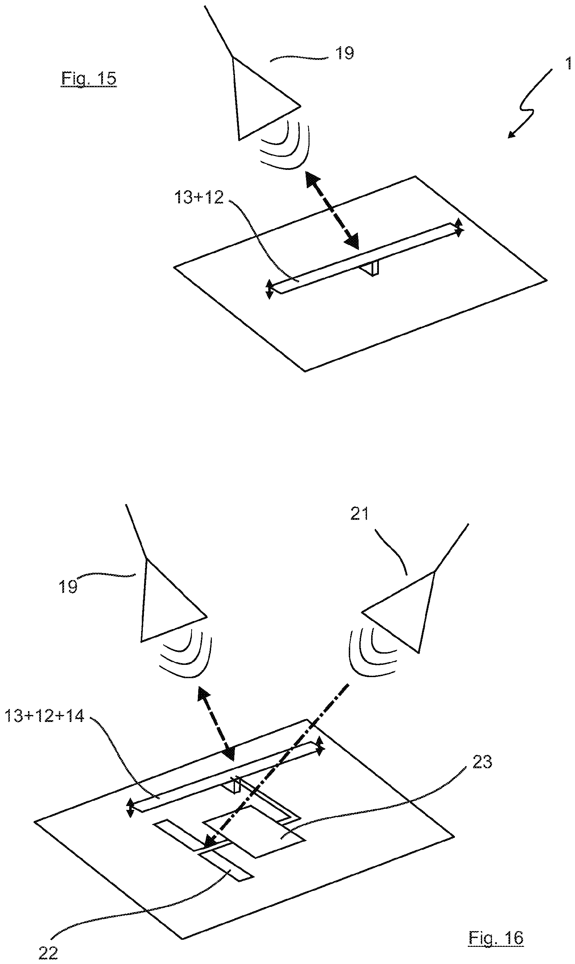

Fig. 15 zeigt eine schematische Darstellung eines elften Ausführungsbeispiels des erfindungsgemäßen Mikrowellenresonator-Magnetfeldsensors 1 in einer räumlichen Schrägansicht.

Hierbei ist ein kontaktloses Auslesen gezeigt, bei dem eine Auslesevorrichtung 19 mit einer Antenne entsprechend auf den Mikrowellenresonator 1 gerichtet ist. Hierbei ist der Mikrowellenresonator 1 als modulierter Streukörper ausgebildet.

Durch unterschiedliche Mikrowellenresonanzfrequenzen einzelner Mikrowellenresonatoren 1 können eine Vielzahl von Mikrowellenresonatoren 1 unterschieden werden.

In Fig. 16 ist eine schematische Darstellung eines zwölften Ausführungsbeispiels des erfindungsgemäßen Mikrowellenresonator-Magnetfeldsensors 1 in einer räumlichen Schrägansicht dargestellt.

Ergänzend zu Fig. 15 ist in diesem Beispiel ein magnetostriktiver Schwinger 12 + 13 mit einem zusätzlichen Piezo-Transducer 14 ausgestattet, wobei zusätzlich zu dessen Ansteuerung ein Dipol für pulsmodulierte Mikrowellen f_{mod} 22 sowie ein Hüllkurvengleichrichter 23 vorgesehen sind, so dass über eine zusätzliche Antenne 21 eine Einstrahlung einer pulsmodulierten Mikrowelle f_{mod} zur Schwingungsanregung vorgesehen ist.

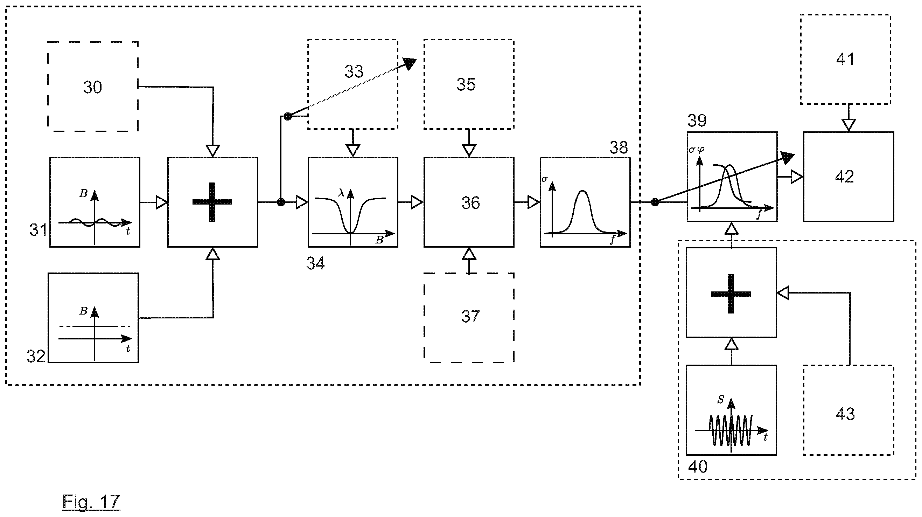

Fig. 17 zeigt eine schematische Darstellung eines Ausführungsbeispiels eines Ausführungsbeispiels einer Frequenzdiskriminatorerkennung für den magnetoelektrischen µw-Resonator 1. Systemrauschenquellen sind durch gestrichelte Kästchen dargestellt. Umgebungslärmquellen sind mit gestrichelten Kästchen gekennzeichnet.

Das Sensorsignal 47 moduliert die µw-Resonanz des Resonators 1, angezeigt durch den Steuerpfeil. Abhängig von der eingestellten µw-Signalfrequenz werden Phase und Amplitude der Mikrowelle moduliert, die als Seitenbänder im Ausgangsspektrum zu sehen sind.

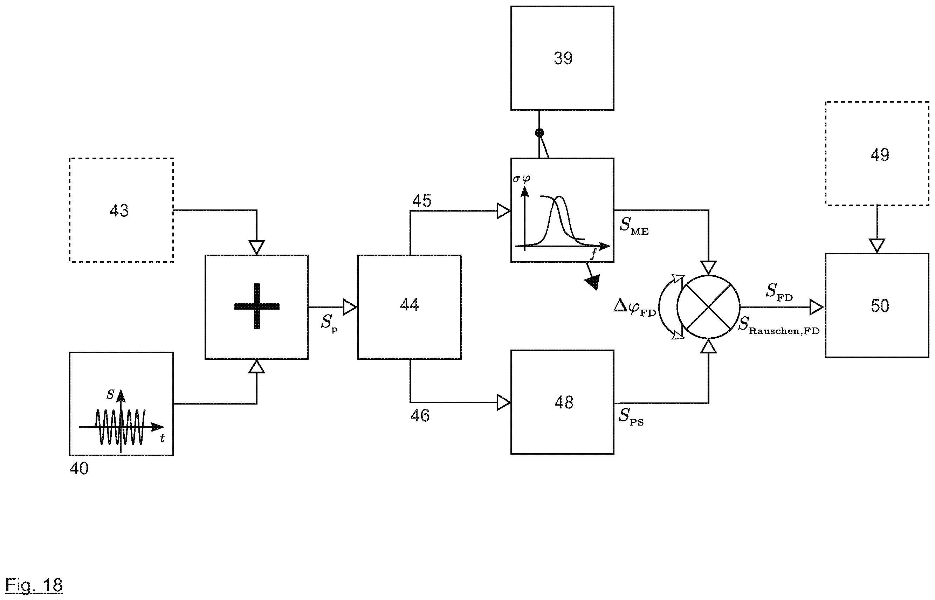

Fig. 18 stellt eine schematische Darstellung eines Ausführungsbeispiels des magnetoelektrischen µw-Resonatorsystems 1 in einem Blockschaltbild dar.

Für dieses Erkennungsschema wird das µw-Auslesesignal durch einen 3-dB-Leistungsteiler 44 in einen Sensor 45 und einen Referenzpfad 46 unterteilt. Es wird eine statische Phasenverschiebung ϕME ohne angelegtes Signal Bs eingeführt. Im Referenzpfad 46 fügt ein in den Signalpfad eingefügter Phasenschieber 48 eine eingestellte Phase ϕPS ein, wobei dieser die Einstellung der relativen Phasendifferenz ΔϕFD= ϕME cpPS am Phasendiskriminator ohne angelegtes Magnetsignal BS ermöglicht.

### Bezugszeichenliste

- 1: Mikrowellenresonator-Magnetfeldmessvorrichtung Mikrowellenresonator-Magnetfeldsensor, kurz auch µW-Sensor
- 11: Grundplatte
- 111: Cantilever- Abstütz-/Lager-/Einspannpunkt
- 12: magnetostriktive Schicht
- 13: Cantilever
- 131: Cantilever-Beabstandung
- 14: Piezo-Transducer
- 15: Split-Ring Resonator
- 161: Einkopplung
- 162: Auskopplung
- 17: Abstimmschraube
- 171: einstellbare Reaktanz
- 18: Ferrit
- 19: Auslesevorrichtung, Antenne
- 21: Einstrahlantenne
- 22: Dipol für pulsmodulierte Mikrowelle fmod
- 23: Hüllkurvengleichrichter
- 30: Magnetisches Umgebungsrauschen
- 31: Magnetisches Signal
- 32: Magnetischer Bias
- 33: Magnetisches Rauschen
- 34: Magnetostriktion
- 35: Thermischmechanisches Rauschen
- 36: Mechanische Kopplung
- 37: Akustisches Rauschen
- 38: Mechanische Resonanz
- 39: HF-Resonanz / µw-Resonanz
- 40: HF-Signal / µw-Resonanz
- 41: Rauschen Signalverarbeitung
- 42: Analoge Signalverarbeitung
- 43: Phasenrauschen
- 44: 3 dB Teiler
- 45: Sensor Zweig
- 46: Referenz Zweig
- 47: Sensorsignal
- 48: Phasenschieber
- 49: Rauschen Spektrumanalysator
- 50: Spektrumanalysator
- E: E-Feld
- H: H-Feld
- f: Frequenz
- T_{O}: Transversale Oszillation
- L_{O}: Longitudinale Oszillation

## Patentansprüche

1. Mikrowellenresonator-Magnetfeldmessvorrichtung (1) zur Messung von magnetischen Wechselfeldern umfassend:
- eine Grundplatte (11) mit wenigstens einem Abstütz-/Lager-/Einspannpunkt (111);
- wenigstens einen als Mikrowellen-Resonator ausgebildeten mechanischen Schwinger (12 + 13) in Form eines Cantilevers (13) mit wenigstens einer magnetostriktiven Schicht (12), wobei dieser wenigstens an einer Stelle mit der Grundplatte (11) in dem wenigstens einen Abstütz-/Lager-/Einspannpunkt (111) verbunden und gelagert ist;
- wenigstens eine Einkopplung (161) für Mikrowellen und
- wenigstens eine Auskopplung (162) für Mikrowellen
wobei die Grundplatte (11) und der als Mikrowellen-Resonator ausgebildete mechanische Schwinger (12 + 13) wenigstens teilweise elektrisch leitfähig ausgebildet und miteinander elektrisch leitfähig verbunden sind
**dadurch gekennzeichnet, dass**
die Mikrowellenresonator-Magnetfeldmessvorrichtung (1) dazu eingerichtet ist, bei Betrieb die mechanische Auslenkung des mechanischen Schwingers (12 + 13) durch Einwirken eines zu messenden magnetischen Wechselfeldes auf die magnetostriktive Schicht (12) mittels des integrierten Mikrowellen-Resonators zu detektieren.

2. Mikrowellenresonator-Magnetfeldmessvorrichtung (1) nach Anspruch 1 oder 2,
**dadurch gekennzeichnet, dass**
die Einkopplung (161) für Mikrowellen und/oder die Auskopplung (162) für Mikrowellen kapazitiv oder induktiv ausgebildet ist.

3. Mikrowellenresonator-Magnetfeldmessvorrichtung (1) nach einem der vorangehenden Ansprüche,
**dadurch gekennzeichnet, dass**
in der Grundplatte (11) eine Abstimmschraube (17) und/oder eine einstellbare Reaktanz (171) und/oder eine Geometrieverstellung zur Verstimmung des als Mikrowellen-Resonator ausgebildeten mechanischen Schwingers (12 + 13) vorgesehen ist.

4. Mikrowellenresonator-Magnetfeldmessvorrichtung (1) nach einem der vorangehenden Ansprüche,
**dadurch gekennzeichnet, dass**
der als Mikrowellen-Resonator ausgebildete mechanische Schwinger (12 + 13):
- in genau einem Punkt (111) an einem der Enden oder in der Mitte
oder
- in genau zwei Punkten (111), dem ersten und dem zweiten Ende des als Mikrowellen-Resonator ausgebildeten mechanischen Schwingers (12 + 13) gelagert ist.

5. Mikrowellenresonator-Magnetfeldmessvorrichtung (1) nach einem der vorangehenden Ansprüche,
**dadurch gekennzeichnet, dass**
die Länge des mit einer leitfähigen Schicht versehenen Abschnitts des Cantilevers (13) die Hälfte der Mikrowellenlänge oder ein Viertel der Mikrowellenlänge beträgt, wobei die magnetostriktive Schicht unterhalb der leitfähigen Schicht über die volle oder auch nur einen Teil der Länge aufgebracht ist.

6. Mikrowellenresonator-Magnetfeldmessvorrichtung (1) nach einem der vorangehenden Ansprüche,
**dadurch gekennzeichnet, dass**
die Mikrowellenresonator-Magnetfeldmessvorrichtung (1) als Hohlraumresonator ausgebildet ist.

7. Mikrowellenresonator-Magnetfeldmessvorrichtung (1) nach einem der vorangehenden Ansprüche 1 bis 5,
**dadurch gekennzeichnet, dass**
die magnetostriktive Schicht (12) als Dünnschicht auf dem Cantilever (13) ausgebildet ist oder
die magnetostriktive Schicht (12) selbst als Cantilever (13) ausgebildet ist.

8. Mikrowellenresonator-Magnetfeldmessvorrichtung (1) nach einem der vorangehenden Ansprüche,
**dadurch gekennzeichnet, dass**
die Mikrowellenresonator-Magnetfeldmessvorrichtung (1) kontaktlos auslesbar und/oder fernauslesbar ist.

9. Mikrowellenresonator-Magnetfeldmessvorrichtung (1) nach einem der vorangehenden Ansprüche,
**dadurch gekennzeichnet, dass**
der als Mikrowellen-Resonator ausgebildete mechanische Schwinger (12 + 13) über ein Piezo-Transducer-Element (14) elektrisch anregbar ist.

10. Magnetfeldmessverfahren mit einer Mikrowellenresonator-Magnetfeldmessvorrichtung (1) nach einem der vorangehenden Ansprüche,
**gekennzeichnet durch**:
das Detektieren einer mechanischen Auslenkung des mechanischen Schwingers durch Einwirken eines zu messenden Magnetfeldes auf die magnetostriktive Schicht mittels des integrierten Mikrowellen-Resonators, wobei
die Mikrowellenresonator-Magnetfeldmessvorrichtung (1) in Mikrowellen-Resonanz betrieben wird.

11. Magnetfeldmessverfahren nach dem vorangehenden Anspruch,
**dadurch gekennzeichnet, dass**
die Mikrowellenresonator-Magnetfeldmessvorrichtung (1) in doppelter Resonanz betrieben wird, wobei dies in Mikrowellen-Resonanz und in mechanischer Resonanz erfolgt, wobei hierbei ein Verstimmen des Mikrowellen-Resonators durch den zugleich in mechanischer Resonanz schwingenden mechanischen Schwinger (12 + 13) erfolgt.

12. Magnetfeldmessverfahren mit einer Mikrowellenresonator-Magnetfeldmessvorrichtung (1) nach einem der vorangehenden Ansprüche 1 bis 9 oder nach den beiden vorangehenden Ansprüchen,
**dadurch gekennzeichnet, dass**
ein Fernauslesen des / der Mikrowellenresonator-Magnetfeldmessvorrichtung (1) erfolgt, wobei die Schwingung des als Mikrowellen-Resonator ausgebildeten mechanischen Schwingers (12 + 13) ohne eigene Energieversorgung durch ein Einstrahlen von gepulster oder intensitätsmodulierter elektromagnetischer Strahlung hoher Energie angeregt wird und ein Auslesen dessen Reaktion / Antwort über Mikrowellenstrahlung erfolgt.

## Claims

1. A microwave resonator magnetic field measuring device (1) for measuring alternating magnetic fields, comprising:
- a base plate (11) with at least one support/bearing/clamping point (111);
- at least one mechanical oscillator (12 + 13) formed as a microwave resonator in the form of a cantilever (13) having at least one magnetostrictive layer (12), the latter being connected and mounted at least at one point to the base plate (11) in the at least one support/bearing/clamping point (111),
- at least one coupling means (161) for microwaves
and
- at least one decoupling means (162) for microwaves,
wherein the base plate (11) and the mechanical oscillator (12 + 13), formed as a microwave resonator, are at least partly electrically conductive and are electrically conductively connected to one another,
wherein
the microwave resonator magnetic field measuring device (1) is set up to detect, during operation, the mechanical deflection of the mechanical oscillator (12 + 13) by the influence of an alternating magnetic field to be measured on the magnetostrictive layer (12) by means of the integrated microwave resonator.

2. Microwave resonator magnetic field measuring device (1) according to claim 1 or 2,
wherein
the coupling (161) for microwaves and/or the decoupling (162) for microwaves is capacitive or inductive.

3. Microwave resonator magnetic field measuring device (1) according to one of the preceding claims,
wherein
a tuning screw (17) and/or an adjustable reactance (171) and/or a geometry adjustment for detuning the mechanical oscillator (12 + 13) designed as a microwave resonator is provided in the base plate (11).

4. Microwave resonator magnetic field measuring device (1) according to one of the preceding claims,
wherein
the mechanical oscillator (12 + 13) designed as a microwave resonator:
- at exactly one point (111) at one of the ends or in the middle
or
- at exactly two points (111), the first and the second end of the mechanical oscillator (12 + 13) designed as a microwave resonator.

5. Microwave resonator magnetic field measuring device (1) according to one of the preceding claims,
wherein
the length of the section of the cantilever (13) provided with a conductive layer is half the microwave length or a quarter of the microwave length, the magnetostrictive layer being applied over the full length or even only part of the length below the conductive layer.

6. Microwave resonator magnetic field measuring device (1) according to any of the preceding claims,
wherein
the microwave resonator magnetic field measuring device (1) is designed as a cavity resonator.

7. microwave resonator magnetic field measuring device (1) according to one of the preceding claims 1 to 5,
wherein
the magnetostrictive layer (12) is applied to the cantilever (13) as a thin layer
or
the magnetostrictive layer (12) itself is formed as a cantilever (13).

8. Microwave resonator magnetic field measuring device (1) according to any one of the preceding claims,
wherein
the microwave resonator magnetic field measuring device (1) can be read out without contact and/or can be read out remotely.

9. Microwave resonator magnetic field measuring device (1) according to one of the preceding claims,
wherein
the mechanical oscillator (12 + 13) is designed as a microwave resonator and is adapted to being electrically excited via a piezo transducer element (14).

10. Magnetic field measuring method with a microwave resonator magnetic field measuring device (1) according to one of the preceding claims,
wherein:
the detection of a mechanical deflection of the mechanical oscillator by applying a magnetic field to be measured to the magnetostrictive layer by means of the integrated microwave resonator, wherein the microwave resonator magnetic field measuring device (1) is operated in microwave resonance.

11. Magnetic field measuring method according to the preceding claim,
wherein
the microwave resonator magnetic field measuring device (1) is operated in double resonance, this being done in microwave resonance and in mechanical resonance, wherein the microwave resonator is detuned by the mechanical oscillator (12 + 13), which simultaneously oscillates in mechanical resonance.

12. Magnetic field measuring method with a microwave resonator magnetic field measuring device (1) according to one of the preceding claims 1 to 9 or according to the two preceding claims,
wherein
a remote readout of the microwave resonator magnetic field measuring device(s) (1) takes place, wherein the oscillation of the mechanical oscillator (12 + 13) in the form of a microwave resonator takes place without its own energy supply by being excited by radiation of pulsed or intensity-modulated electromagnetic radiation of high energy, and a readout of its reaction/response takes place via microwave radiation.

## Revendications

1. Dispositif de mesure de champ magnétique à résonateur micro-ondes (1) pour mesurer des champs magnétiques alternatifs comprenant :
- une plaque de base (11) avec au moins un point d'appui/de support/de serrage (111);
- au moins un oscillateur mécanique (12 + 13) conçu comme un résonateur à micro-ondes sous la forme d'un cantilever (13) comportant au moins une couche magnétostrictive (12), cette dernière étant reliée et montée au moins en un point à la plaque de base (11) dans le au moins un point d'appui/de support/de serrage (111);
- au moins un couplage (161) pour les micro-ondes et
- au moins un moyen de découplage (162) pour les micro-ondes dans lequel la plaque de base (11) et l'oscillateur mécanique (12 + 13) formé comme un résonateur à micro-ondes sont au moins partiellement conducteurs d'électricité et sont connectés électriquement l'un à l'autre
**caractérisé en ce que**
le dispositif de mesure de champ magnétique à résonateur à micro-ondes (1) est conçu pour détecter, pendant le fonctionnement, la déviation mécanique de l'oscillateur mécanique (12 + 13) sous l'effet d'un champ magnétique alternatif à mesurer sur la couche magnétostrictive (12) au moyen du résonateur à micro-ondes intégré.

2. Dispositif de mesure de champ magnétique à résonateur micro-ondes (1) selon la revendication 1 ou 2,
**caractérisé en ce que**
le couplage (161) pour les micro-ondes et/ou le découplage (162) pour les micro-ondes est capacitif ou inductif.

3. Dispositif de mesure de champ magnétique à résonateur micro-ondes (1) selon l'une des revendications précédentes,
**caractérisé en ce que**
il est prévu dans la plaque de base (11) une vis d'accord (17) et/ou une réactance réglable (171) et/ou un réglage de la géométrie pour désaccorder l'oscillateur mécanique (12 + 13) conçu comme un résonateur à micro-ondes.

4. Dispositif de mesure de champ magnétique à résonateur micro-ondes (1) selon l'une des revendications précédentes,
**caractérisé en ce que**
l'oscillateur mécanique (12 + 13) conçu comme un résonateur à micro-ondes :
- en un seul point (111) à l'une des extrémités ou au milieu
ou
- en exactement deux points (111), la première et la deuxième extrémité de l'oscillateur mécanique (12 + 13) conçu comme un résonateur à micro-ondes.

5. Dispositif de mesure de champ magnétique à résonateur micro-ondes (1) selon l'une des revendications précédentes,
**caractérisé en ce que**
la longueur de la section du cantilever (13) pourvue d'une couche conductrice est la moitié de la longueur des micro-ondes ou un quart de la longueur des micro-ondes, la couche magnétostrictive étant appliquée sur toute la longueur ou même seulement sur une partie de la longueur, en dessous de la couche conductrice.

6. Dispositif de mesure de champ magnétique à résonateur micro-ondes (1) selon l'une des revendications précédentes,
**caractérisé en ce que**
le dispositif de mesure du champ magnétique à résonateur micro-ondes (1) est conçu comme un résonateur à cavité.

7. Dispositif de mesure de champ magnétique à résonateur micro-ondes (1) selon l'une des revendications 1 à 5 précédentes,
**caractérisé en ce que**
la couche magnétostrictive (12) est réalisée sous forme de couche mince sur le cantilever (13)
ou
la couche magnétostrictive (12) est elle-même conçue comme un cantilever (13).

8. Dispositif de mesure de champ magnétique à résonateur micro-ondes (1) selon l'une des revendications précédentes,
**caractérisé en ce que**
le dispositif de mesure de champ magnétique à résonateur micro-ondes (1) peut être lu sans contact et/ou à distance.

9. Dispositif de mesure de champ magnétique à résonateur micro-ondes (1) selon l'une des revendications précédentes,
**caractérisé en ce que**
le résonateur mécanique (12 + 13) conçu comme un résonateur à micro-ondes peut être excité électriquement par un élément transducteur piézoélectrique (14).

10. Procédé de mesure de champ magnétique avec un dispositif de mesure de champ magnétique à résonateur à micro-ondes (1) selon l'une des revendications précédentes,
**caractérisé par** :
la détection d'une déviation mécanique de l'oscillateur mécanique en appliquant un champ magnétique à mesurer à la couche magnétostrictive au moyen du résonateur à micro-ondes intégré, le dispositif de mesure du champ magnétique à résonateur à micro-ondes (1) fonctionnant en résonance micro-ondes.

11. Procédé de mesure de champ magnétique selon la revendication précédente,
**caractérisé en ce que**
le dispositif de mesure de champ magnétique à résonateur micro-ondes (1) fonctionne en double résonance, ce qui se fait en résonance micro-ondes et en résonance mécanique, un désaccord du résonateur micro-ondes étant effectué par l'oscillateur mécanique (12 + 13) qui oscille simultanément en résonance mécanique.

12. Procédé de mesure de champ magnétique avec un dispositif de mesure de champ magnétique à résonateur micro-ondes (1) selon l'une des revendications 1 à 9 précédentes ou selon les deux revendications précédentes,
**caractérisé en ce que**
une extraction à distance du / des dispositif(s) de mesure de champ magnétique à résonateur à micro-ondes (1) est effectuée, l'oscillation de l'oscillateur mécanique (12 + 13) conçu comme un résonateur à micro-ondes étant excitée sans alimentation en énergie propre par une irradiation de rayonnement électromagnétique pulsé ou modulé en intensité de haute énergie et une extraction de sa réaction / réponse étant effectuée par rayonnement micro-ondes.
